# EUROPÄISCHE PATENTSCHRIFT

(11) **EP 1 872 411 B1**
(45) Veröffentlichungstag und Bekanntmachung des Hinweises auf die Patenterteilung: **24.09.2008**
(21) Anmeldenummer: 06724249.5
(22) Anmeldetag: 11.04.2006
(51) Int. Cl.: H01L 31/0224, H01L 31/18

(54) **RÜCKKONTAKTIERTE SOLARZELLE UND VERFAHREN ZU DEREN HERSTELLUNG**
REAR CONTACT SOLAR CELL AND METHOD FOR MAKING SAME
CELLULE SOLAIRE A CONTACT ARRIERE ET PROCEDE DE FABRICATION ASSOCIE

(30) Priorität: 16.04.2005 DE 102005017767; 29.08.2005 DE 102005040871
(43) Veröffentlichungstag der Anmeldung: 02.01.2008
(73) Patentinhaber: Institut für Solarenergieforschung GmbH, 31860 Emmerthal (DE)
(72) Erfinder: ENGELHART, Peter, 31785 Hameln (DE); TEPPE, Andreas, 63755 Alzenau (DE); GRISCHKE, Rainer, 31134 Hildesheim (DE); WADE, Robert, 04109 Leipzig (DE)
(74) Vertreter: Maiwald Patentanwalts GmbH
(86) Internationale Anmeldenummer: PCT/EP2006/003331
(87) Internationale Veröffentlichungsnummer: WO 2006/111304

(56) Entgegenhaltungen:
- EP-A- 0 881 694
- DE-A1-3102004 053 87
- US-A- 4 838 952
- US-A1- 2004 200 520

## Beschreibung

### Gebiet der Erfindung

Die vorliegende Erfindung betrifft eine Solarzelle, bei der sowohl ein Emitterkontakt als auch ein Basiskontakt an einer Rückseite eines Halbleitersubstrates angeordnet sind, und ein Verfahren zu deren Herstellung.

### Hintergrund der Erfindung

Solarzellen dienen dazu, Licht in elektrische Energie umzuwandeln. Dabei werden in einem Halbleitersubstrat durch Licht erzeugte Ladungsträgerpaare durch einen pn-Übergang getrennt und dann über den Emitterkontakt und den Basiskontakt einem einen Verbraucher aufweisenden Stromkreis zugeführt.

### Stand der Technik

Bei herkömmlichen Solarzellen ist der Emitterkontakt meist auf der Vorderseite, d.h. der der Lichtquelle zugewandten Seite, des Halbleitersubstrats angeordnet. Es wurden jedoch, z.B. in JP 5-75149 A, DE 41 43 083 und DE 101 42 481, auch Solarzellen vorgeschlagen, bei denen sowohl der Basiskontakt als auch der Emitterkontakt auf der Substratrückseite angeordnet ist. Dadurch wird einerseits eine Abschattung der Vorderseite durch die Kontakte vermieden, was zu einem gesteigerten Wirkungsgrad wie auch zu einer verbesserten Ästhetik der Solarzelle führt, andererseits lassen sich solche Solarzellen leichter in Serie verschalten, da die Rückseite einer Zelle nicht mit der Vorderseite einer benachbarten Zelle kontaktiert werden muss. Das Dokument US-A-2004/200520 beschreibt ein Verfahren zum Herstellen einer Solarzelle.

Mit anderen Worten birgt eine Solarzelle ohne Vorderseitenmetallisierung mehrere Vorteile: Die Solarzellenvorderseite wird durch keinen Kontakt abgeschattet, sodaß die einfallende Strahlungsenergie uneingeschränkt Ladungsträger im Halbleitersubstrat erzeugen kann. Außerdem lassen sich diese Zellen einfacher zu Modulen verschalten und sie besitzen eine hohe Ästhetik.

Allerdings weisen herkömmliche sog. Rückkontaktsolarzellen mehrere Nachteile auf. Ihre Herstellungsverfahren sind meist aufwendig. Bei manchen Verfahren sind mehrere Maskierungsschritte, mehrere Ätzschritte und/oder mehrere Aufdampfschritte notwendig, um den Basiskontakt elektrisch getrennt von dem Emitterkontakt an der Rückseite des Halbleitersubstrates auszubilden. Des weiteren leiden herkömmliche Rückkontaktsolarzellen oft unter lokalen Kurzschlüssen, bedingt z.B. durch Inversionsschichten zwischen dem Basis- und dem Emitterbereich oder durch mangelnde elektrische Isolierung zwischen dem Emitter- und dem Basiskontakt, was zu einem reduzierten Wirkungsgrad der Solarzelle führt.

Eine Solarzelle ohne Vorderseitenmetallisierung ist beispielsweise aus R.M. Swanson "Point Contact Silicon Solar Cells" Electric Power Research institute Rep. AP-2859, May 1983 bekannt. Dieses Zellkonzept wurde ständig weiterentwickelt (R.A. Sinton "Bilevel contact solar cells", US Patent 5,053,083, 1991). Eine vereinfachte Version dieser Punktkontakt-Solarzelle wird von der Firma SunPowerCorporation in einer Pilotlinie hergestellt (K.R. McInthosh, M.J. Cudzinovic, D-D Smith, W-P. Mulligan, and R.M. Swanson "The choice of silicon wafer for the production of low-cost rear-contact solar cells" 3rd World Conference of PV energie convercion Osaka 2003 in press).

Zu deren Herstellung werden dabei in mehreren Maskierungsschritten unterschiedlich dotierte Gebiete nebeneinander erzeugt und durch Aufbringen einer teilweise mehrschichtigen Metallstruktur metallisiert bzw. kontaktiert.

Nachteilig ist dabei, dass diese Verfahren mehrere justierende Maskenschritte benötigen und dadurch aufwendig sind.

Aus Patent JP 5-75149A ist eine Solarzelle ohne Vorderseitenmetallisierung bekannt, die erhabene und abgesenkte Bereiche auf der Rückseite der Solarzelle besitzt. Diese Solarzelle ist ebenfalls nur mit mehreren Maskierungs- und Ätzschritten herzustellen.

In Patent DE 41 43 083 wird eine Solarzelle ohne Vorderseitenmetallisierung beschrieben, bei der justierende Maskenschritte nicht zwingend notwendig sind. Der Wirkungsgrad dieser Zelle ist aber gering, da die Inversionsschicht beide Kontaktsysteme verbindet, was einen geringen Parallelwiderstand und damit einen geringen Füllfaktor bewirkt.

In Patent DE 101 42 481 ist eine Solarzelle beschrieben mit Basis- und Emitterkontakt auf der Rückseite. Auch diese Solarzelle besitzt eine Rückseitenstruktur, die Kontakte befinden sich aber an den Flanken der Erhebungen. Dies erfordert zwei Vakuumaufdampfschritte zur Kontaktherstellung. Außerdem ist das Herstellen eines lokalen Emitters technologisch anspruchsvoll bei dieser Zelle.

Eine besondere Schwierigkeit bei rückseitig kontaktierten Solarzellen ist die aufwendige Herstellung der Rückseitenkontakte, bei der elektrische Kurzschlüsse unbedingt vermieden werden müssen.

### Aufgabenstellung

Es ist eine Aufgabe der vorliegenden Erfindung, die oben genannten Probleme zu vermeiden oder zumindest zu vermindern und eine Solarzelle und ein Herstellungsverfahren für eine Solarzelle anzugeben, die einen hohen Wirkungsgrad erreicht und einfach herzustellen ist.

Die Aufgabe wird erfindungsgemäß durch ein Herstellungsverfahren und eine Solarzelle mit den Merkmalen der unabhängigen Ansprüche gelöst. Vorteilhafte Ausführungsformen und Weiterbildungen der Erfindung ergeben sich aus den abhängigen Ansprüchen.

Insbesondere wird durch diese Erfindung das Problem der Herstellung der beiden rückseitigen Kontaktsysteme und deren einwandfreien elektrischen Trennung auf einfache Weise gelöst sowie eine hierdurch einfach herzustellende Solarzelle beschrieben. Unabhängig von der Art der elektrischen Trennung der beiden rückseitigen Kontaktsysteme kann die Solarzelle selbst als Emitter-Wrap-Through-Solarzelle (EWT) ausgeführt werden.

### Beschreibung der Erfindung

Gemäß einem ersten Aspekt der Erfindung wird ein Verfahren zum Herstellen einer Solarzelle angegeben, dass die folgenden Schritte aufweist: Bereitstellen eines Halbleitersubstrats mit einer Substratvorderseite und einer Substratrückseite; Ausbilden eines ersten und eines zweiten Bereichs an der Substratrückseite, wobei die Bereiche jeweils im Wesentlichen parallel zu der Substratvorderseite sind, und Ausbilden einer geneigten Flanke, die den ersten Bereich von dem zweiten Bereich trennt; Abscheiden einer Metallschicht zumindest auf Teilbereiche der Substratrückseite; Abscheiden einer Ätzbarrierenschicht zumindest auf Teilbereiche der ersten Metallschicht, wobei die Ätzbarrierenschicht im Wesentlichen resistent gegen eine die Metallschicht ätzende Ätze ist; Ätzen der Metallschicht zumindest in Teilbereichen, wobei die Metallschicht an der geneigten Flanke im Wesentlichen entfernt wird.

Als Halbleitersubstrat kann ein Siliziumwafer verwendet werden. Das Verfahren eignet sich insbesondere für die Verwendung bei Siliziumwafern minderer Qualität, beispielsweise aus multikristallinem Silizium oder Cz-Silizium, mit einer Minoritätsladungsträgerdiffusionslänge, die kürzer ist als die Dicke des Wafers.

Mit dem ersten und dem zweiten Bereich an der Substratrückseite sind diejenigen Bereiche gemeint, die bei der fertiggestellten Solarzelle den Emitterbereich und den Basisbereich der Solarzelle definieren und unterschiedliche Dotierungen vom n-Typ bzw. vom p-Typ aufweisen. Beide Bereiche sind vorzugsweise eben. Um eine gleichmäßige Verteilung der beiden Bereiche über die Substratrückseite zu erreichen, können die beiden Bereiche kammartig ("interdigitated") ineinander verschachtelt sein. Eine Haupterstreckungsrichtung der Bereiche ist im Wesentlichen parallel zu der Substratvorderseite. Dies gilt auch dann, wenn einzelne Teilbereiche nicht eben sind, z.B. wenn die einzelnen Finger einer kammartigen Struktur einen U-förmigen Querschnitt aufweisen.

Erfindungsgemäß trennt mindestens eine Flanke den ersten und den zweiten Bereich voneinander. Unter einer Flanke sei hierbei eine Fläche verstanden, die in Bezug auf die Substratvorderseite, und damit auch auf die Ebenen des ersten und des zweiten Bereichs, einen Winkel von mindestens 60° aufweist. Vorzugsweise ist der Winkel möglichst steil, beispielsweise über 80°, und am stärksten bevorzugt etwa senkrecht zur Ebene der Substratvorderseite. Selbst überhängende Winkel von mehr als 90°, so dass die Flanke die Substratrückseite hinterschneidet, sind möglich.

Vorzugsweise wird die Flanke mittels eines Lasers ausgebildet. Dabei kann beispielsweise im ersten Bereich durch Bestrahlung mit einem hochenergetischen Laser geeigneter Emissionswellenlänge Substratmaterial abgetragen werden, so dass der erste Bereich der Substratvorderseite näher ist als der zweite Bereich, d.h., dass das Substrat im ersten Bereich dünner ist als im zweiten Bereich. Am Übergang vom ersten, tieferliegenden, grabenförmigen Bereich zum zweiten, höherliegenden, erhabenen Bereich wird dabei die Flanke ausgebildet. Wenn die beiden Bereiche, wie oben beschrieben, kammartig verschachtelt ausgebildet sind, erstreckt sich die Flanke entlang der gesamten Kammstruktur.

Das Abscheiden einer Metallschicht erfolgt vorzugsweise auf der gesamten Substratrückseite. Eine Maskierung, beispielsweise durch Fotolithographie, einzelner Bereiche der Substratrückseite ist nicht nötig. Eventuell bleiben Teilbereiche der Substratrückseite, die zum Halten des Substrats während der Abscheidung dienen, von der Metallschicht frei. Für die Metallschicht wird vorzugsweise Aluminium verwendet.

Nach dem Abscheiden der Metallschicht wird auf diese, zumindest wiederum in Teilbereichen, eine Ätzbarrierenschicht abgeschieden. Die Ätzbarrierenschicht überdeckt somit die Metallschicht zumindest teilweise.

Die Ätzbarrierenschicht ist erfindungsgemäß im Wesentlichen resistent gegen eine die Metallschicht ätzende Ätze. Das bedeutet, dass eine Ätze, beispielsweise eine flüssige Ätzlösung oder ein reaktives Gas, die die Metallschicht stark angreift, die Ätzbarrierenschicht nicht oder wenig ätzt. Beispielsweise soll die Ätzrate der Ätze bezogen auf die Metallschicht sehr viel höher sein, beispielsweise um einen Faktor zehn, als bezogen auf die Ätzbarrierenschicht. Für die Ätzbarrierenschicht können beispielsweise Metalle wie Silber oder Kupfer; aber auch Dielektrika wie Siliziumoxid oder Siliziumnitrid, verwendet werden

In einem nachfolgenden Verfahrensschritt wird die Substratrückseite mit der darauf befindlichen Metallschicht und der diese überdeckenden Ätzbarrierenschicht der Ätze ausgesetzt. In den von der Ätzbarrierenschicht überdeckten Bereichen wird die Metallschicht von der Ätze nicht oder kaum angegriffen. Im Flankenbereich jedoch, in dem aufgrund seiner geneigten Anordnung in Bezug auf den ersten und den zweiten Bereich an der Substratrückseite die Ätzbarrierenschicht nur sehr dünn, löchrig oder gar nicht ausgebildet ist, kann die Ätze direkt die Metallschicht angreifen. Die Ätzbarrierenschicht wird zusätzlich unterätzt oder weist ohne die darunterliegende, weggeätzte Metallschicht nicht genügend Stabilität auf und wird durch den Ätzschritt letztendlich vorzugsweise vollständig entfernt. Im Ergebnis ist die Metallschicht im ersten Bereich nicht mehr elektrisch mit der Metallschicht im zweiten Bereich verbunden.

Vorzugsweise wird für die Ätzbarrierenschicht ein Metall verwendet, welches lötbar ist, beispielsweise Silber oder Kupfer. Unter dem Begriff "lötbar" sei hierbei verstanden, dass an die Ätzbarrierenschicht ein herkömmliches Kabel oder ein Kontaktstreifen gelötet werden kann, der beispielsweise zur Verschaltung der Solarzellen untereinander dienen kann. Hierbei sollen einfache, kostengünstige Lötverfahren ohne den Einsatz von Spezialloten oder Spezialwerkzeugen, wie sie zum Beispiel zum Verlöten von Aluminium oder Titan oder Verbindungen solcher Metalle notwendig sind, verwendet werden können. Beispielsweise soll die Ätzbarrierenschicht mittels herkömmlichem Silberlot und herkömmlichen Lötkolben lötbar sein.

Durch die Verwendung einer verlötbaren Ätzbarrierenschicht wird erreicht, dass die Ätzbarrierenschicht nach dem Ätzen nicht von der Zelloberfläche entfernt werden muss, um die darunter liegende Metallschicht während einer Verschaltung von Solarzellen miteinander mit einem Kontaktstreifen zu verlöten.

Vorzugsweise wird die die Metallschicht und/oder die Ätzbarrierenschicht gerichtet in einer Richtung im Wesentlichen senkrecht zu dem ersten und zweiten Bereich abgeschieden. Dieses Abscheiden kann durch Aufdampfen, z.B. thermisch oder durch Elektronenstrahl, oder durch Aufsputtern erfolgen. Die Gerichtetheit der Abscheidung resultiert dabei aus Geometrie, mit der die Halbleitersubstrate während der Abscheidung in Bezug auf die Quelle, aus der das Material der jeweiligen Schicht austritt, angeordnet sind. Die Materialpartikel aus der Quelle sollten im Mittel etwa senkrecht, beispielsweise unter einem Winkel von 90°± 20°, auf den ersten und den zweiten Bereich auftreffen.

Dadurch wird erreicht, dass sich an dem ersten und dem zweiten Bereich wesentlich mehr Metall abscheidet als an der diese Bereiche trennenden Flanke, da die Flanke in Bezug auf die Ausbreitungsrichtung der Materialpartikel einen spitzen Winkel von vorzugsweise weniger als 30° aufweist. Die Ätzbarrierenschicht wird nur sehr dünn abgeschieden, so dass sie im ersten und zweiten Bereich eine Dicke von weniger als 5 µm, vorzugsweise weniger als 2 µm, stärker bevorzugt weniger als 500nm, aufweist. Im geneigten Flankenbereich ist die Ätzbarrierenschicht dann so dünn bzw. weist ein poröse Struktur auf, dass sie dort nicht mehr effektiv als Ätzbarriere dienen kann.

In einer Ausführungsform der Erfindung wird das bisher beschriebene Verfahren für die Herstellung sogenannter EWT-Solarzellen (Emitter Wrap Through) verwendet. Dabei wird ein den rückseitigen Emitterbereich der Solarzelle bildender Bereich über ebenfalls mit einer Emitterdotierung versehene Verbindungskanäle mit einem Emitter an der Vorderseite der Solarzelle elektrisch verbunden. Vorzugsweise wird dabei das gesamte Halbleitersubstrat an seinen Oberflächen mit einer dielektrischen Schicht, beispielsweise einem über 100nm dicken thermischen Oxid, versehen und dieses Oxid anschließend an der Substratvorderseite selektiv naßchemisch entfernt. An der Substratrückseite wird in den späteren Emitterbereichen das Oxid mit samt dem darunter liegenden Substratmaterial mittels eines Lasers abgetragen, tief genug, damit sich eine ausreichende, wenigstens einige Mikrometer hohe Flanke ausbildet. Gleichzeitig werden mit dem Laser die Verbindungskanäle hin zur Substratvorderseite ausgebildet. Während einer anschließenden Emitterdiffusion dient die verbleibende dielektrische Schicht für die darunter liegenden Bereiche als Diffusionsbarriere, so dass nur in den zuvor freigelegten Bereichen der Vorder- und der Rückseite sowie in den Verbindungskanälen ein Emitter eindiffundiert wird.

Die Verwendung des erfindungsgemäßen Verfahrens zur Herstellung von EWT-Solarzellen hat den Vorteil, dass in einem gemeinsamen Verfahrensschritt mittels eines hochenergetischen Lasers sowohl die rückseitigen Emitterbereiche von einer darüberliegenden Diffusionsbarrierenschicht freigelegt werden können als auch die Verbindungskanäle hin zum Vorderseitenemitter ausgebildet werden können.

In einer weiteren Ausführungsform des erfindungsgemäßen Verfahrens werden zwischen dem ersten und dem zweiten Bereich mehrere Flanken ausgebildet. Dies kann beispielsweise dadurch erfolgen, dass mit einem Laser zwischen dem ersten und dem zweiten Bereich Gräben ausgebildet werden, die jeweils zusätzliche, annähernd senkrecht angeordnete Flanken aufweisen. Auf diese Weise kann für eine noch zuverlässigere elektrische Trennung des ersten und des zweiten Bereichs gesorgt werden.

Gemäß einem zweiten Aspekt der vorliegenden Erfindung wird eine Solarzelle vorgeschlagen, aufweisend: ein Halbleitersubstrat mit einer Substratvorderseite und einer Substratrückseite; einen Basisbereich eines ersten Dotierungstyps an der Substratrückseite, einen Emitterbereich eines zweiten Dotierungstyps an der Substratrückseite und einen Emitterbereich des zweiten Dotierungstyps an der Substratvorderseite, wobei der Basisbereich und der Emitterbereich an der Substratrückseite durch einen zu diesen Bereichen geneigt angeordneten Flankenbereich getrennt sind; einen Basiskontakt, der den Basisbereich wenigstens in Teilbereichen elektrisch kontaktiert, und einen Emitterkontakt, der den Emitterbereich an der Substratrückseite wenigstens in Teilbereichen elektrisch kontaktiert, wobei der Basiskontakt und der Emitterkontakt jeweils eine erste das Halbleitersubstrat kontaktierende Metallschicht aufweisen, die jeweils im Wesentlichen parallel zu der Substratvorderseite ist, wobei der Flankenbereich keine Metallschicht aufweist, so dass der Emitterkontakt und der Basiskontakt elektrisch getrennt sind, wobei der Emitterbereich an der Substratrückseite durch emitterdotierte Verbindungskanäle mit dem Emitterbereich an der Substratvorderseite verbunden ist.

Die Solarzelle kann insbesondere die Merkmale, wie sie durch das oben beschriebene erfingungsgemäße Verfahren ausbildbar sind, aufweisen.

Mit anderen Worten kann das Funktionsprinzip der Erfindung kurz wie folgt beschrieben werden:
Das elegante und neue Prinzip der Kontakttrennung beruht auf dem Aufdampfen oder Aufsputtern einer dünnen Aluminiumschicht zur Kontaktierung der n- und p-dotierten Zellbereiche. Eine hierauf anschließend aufgedampfte oder aufgesputterte Silber oder Kupferschicht gewährleistet die Lötfähigkeit der Solarzelle und dient gleichzeitig als Ätzbarriere für den Angriff einer Ätzlösung in einem der nächsten Herstellungsschritte.
An den flankenartigen Strukturen am Übergang zwischen den erhabenen und vertieften Bereichen der Solarzellenrückseite ist durch das Metallisierungsverfahren bedingt, die zuletzt abgeschiedene und als Ätzbarriere verwendete Schicht nicht vollständig dicht und ermöglicht so den Angriff einer Ätzlösung, welche die zuerst abgeschiedene Metallschicht an diesen Bereichen definiert entfernt. Die Ätzbarriere selbst wird hierbei unterätzt und deren etwaige Reste können in einem zweiten Ätzschritt, welcher die Ätzbarriere selber angreift, besonders an den unterätzten Bereich der flankenartigen Strukturen schnell entfernt werden.

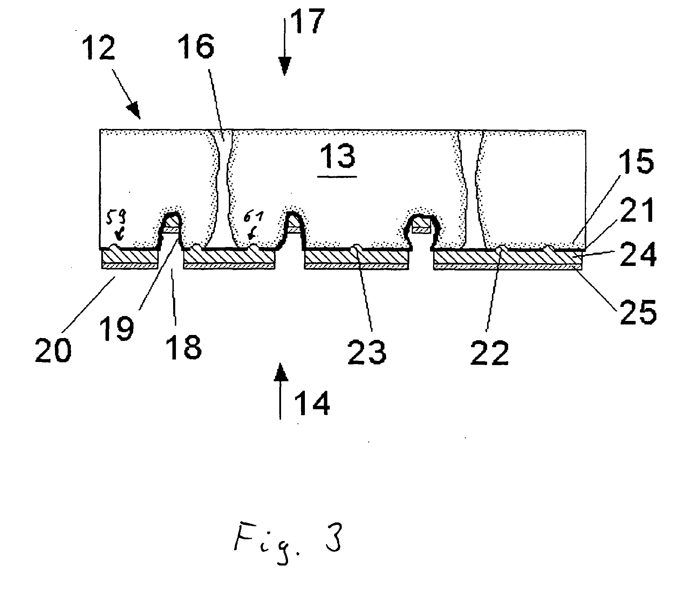

Eine Verstärkung dieses Effektes wird erstmals durch die Verwendung von zwei oder mehr dicht nebeneinander liegenden Gräben (wie weiter unten in Bezug auf Fig.3 beschrieben) erzielt. Durch einen Unterätzungseffekt wird die gesamte Metallisierung des schmalen erhabenen Bereiches zwischen den dicht nebeneinander liegende Gräben definiert entfernt.

Die schmalen Gräben selbst können durch Laserprozesse schnell und preiswert hergestellt werden.

Weitere Merkmale und Vorteile der Erfindung ergeben sich aus der nachfolgenden detaillierten Beschreibung bevorzugter Ausführungsformen im Zusammenhang mit den begleitenden Zeichnungen.

### Kurze Beschreibung der Zeichnungen

Fig. 1 veranschaulicht schematisch einen erfindungsgemäßen Verfahrensablauf.
Fig. 2 zeigt schematisch eine Schnittansicht einer erfindungsgemäßen Solarzelle gemäß einer ersten Ausführungsform.
Fig. 3 zeigt schematisch eine Schnittansicht einer erfindungsgemäßen Solarzelle gemäß einer zweiten Ausführungsform.
Fig. 4 zeigt schematisch eine Schnittansicht einer erfindungsgemäßen Solarzelle gemäß einer dritten Ausführungsform.

### Beschreibung bevorzugter Ausführungsformen

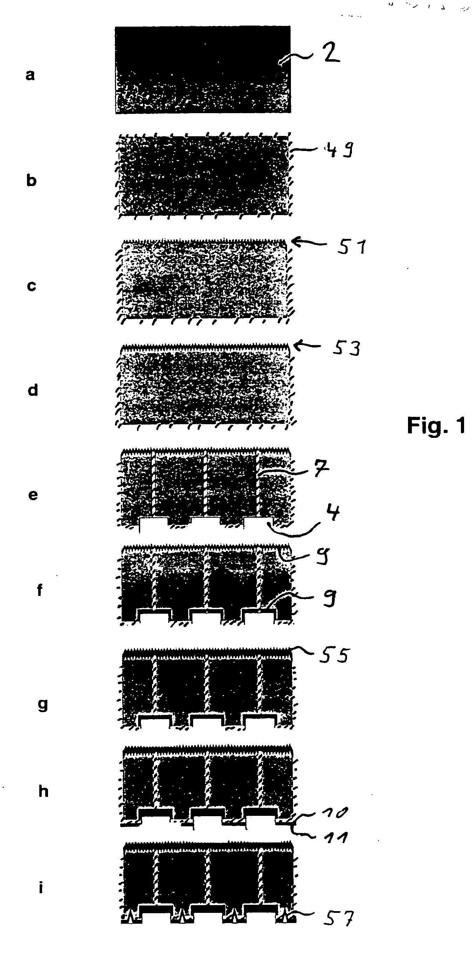

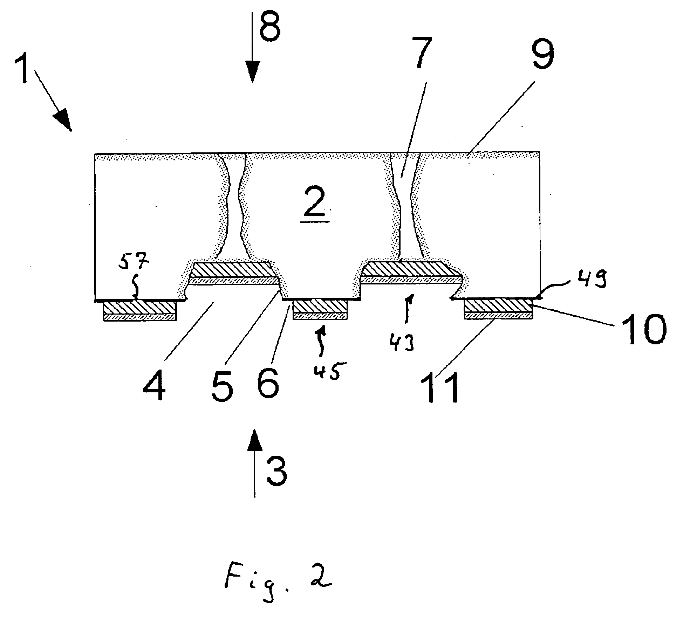

Es wird nun mit Bezug auf Fig. 1 zunächst eine Ausführungsform eines erfindungsgemäßen Herstellungsverfahrens beschrieben, wie es in ähnlicher Weise zur Herstellung der in Fig. 2 gezeigten erfindungsgemäßen Solarzelle 1 verwendbar ist.

Ein Siliziumwafer 2 wird zunächst (in Schritt a) in einem erwärmten Ultraschallbad einer Tensid-Reinigung unterzogen. Anschließend wird der beim Sägen des Wafers entstandene Schaden in erwärmter KOH abgeätzt, wobei die äußersten etwa 10 µm des Wafers entfernt werden. Nachfolgend wird der Wafer einer sog. RCA-Reinigung unterzogen, wobei die Waferoberfläche durch eine Folge von NH₄OH- HF-, HCl- und HF-Spülungen aufoxidiert und das Oxid anschließend abgeätzt wird.

Als nächstes wird (in Schritt b) die gesamte Waferoberfläche in einer N₂/O₂-Atmosphäre bei etwa 1050°C bis zu einer Oxiddicke von etwa 250nm aufoxidiert.

Diese Oxidschicht 49 wird (in Schritt c) auf der späteren Zellvorderseite 8 durch einen horizontalen Ätzprozess in einem HF-Bad entfernt und auf der freigelegten Substratvorderseite durch einen Dip in erwärmter Texturlösung, z.B. einer Lösung aus KOH und IPA (isopropylalkohol), eine Oberflächentextur 51 erzeugt.

Dann wird (in Schritt d) die texturierte Substratvorderseite durch Abscheiden einer etwa 60nm dicken SiN-Schicht 53 geschützt.

In einem nachfolgenden Schritt (e) werden mittels eines hochenergetischen Lasers Teile der Substratrückseite 3 und der darauf befindlichen Oxidschicht 49 entfernt und so erste, grabenförmige Bereiche 4 erzeugt. Die ersten Bereiche 4 sind durch Flanken 5 von zweiten, erhabenen Bereichen 6 getrennt (Fig. 2). Der Grabenindex, d.h. der Abstand von der Mitte eines ersten Bereichs zur Mitte eines benachbarten ersten Bereichs, ist hierbei 2,5mm, die Grabenbreite beträgt 1,25mm.

Im gleichen Verfahrensschritt (e) werden mittels des Laser Verbindungskanäle 7 von den ersten Bereichen 4 hin zur Substratvorderseite 8 erzeugt.

Nach einer erneuten Reinigung des Wafers mit Wasser verdünnter HCl (+ evtl. Ultraschall) und optional in NH₄OH wird der beim Lasern entstandene Schaden in erwärmter KOH etwa 10 µm tief abgeätzt. Es folgt eine weitere Reinigung in heißer HNO₃ und anschließend in kalter HF, bevor (in Schritt f) an der gesamten nicht durch Oxid 49 bedeckten Substratoberfläche ein Emitter mittels einer POCl₃-Diffusion im Rohrofen eindiffundiert wird. Der Schichtwiderstand des Emitters wird dabei auf etwa 40 Ohm/Square eingestellt.

Es folgt eine erneute RCA-Reinigung bevor (in Schritt g) eine Doppelschicht 55 aus SiN auf der Substratvorderseite abgeschieden wird. Die erste SiN-Schicht dient der Oberflächenpassivierung und ist etwa 10nm dick. Die zweite Schicht dient als Antireflexschicht und ist bei einem Brechungsindex von beispielsweise 2,05 etwa 100nm dick.

Nach einer verkürzten RCA-Reinigung, bei der der abschließende HF-Dip weggelassen wird, wird in einer N₂/O₂-Atmosphäre bei 500°C ein nur 1,5nm dickes Tunneloxid erzeugt.

Anschließend wird (in Schritt h) die Rückseite metallisiert. Dazu wird mittels einer Elektronenstrahlkanone zuerst eine etwa 15 µm dicke Metallschicht 10 aus Aluminium aufgedampft. Die Dicke der Aluminiumschicht bezieht sich dabei auf die zur Ausbreitungsrichtung des Aluminiumdampfs etwa senkrecht ausgerichteten ersten und zweiten Bereiche 4, 6 der Substratrückseite. An den dazu geneigt ausgerichteten Flanken 5 wird entsprechend (etwa in einer Kosinusabhängigkeit) dem Winkel der Neigung weniger Aluminium abgeschieden. Nachfolgend wird ebenfalls mittels der Elektronenkanone eine etwa 2 µm dicke Metallschicht 11 aus Silber über das Aluminium abgeschieden.

Die Silberschicht 11 dient in einem anschließenden selektiven Ätzschritt als Ätzbarrierenschicht. Als Ätze wird hierbei HCl verwendet, die Aluminium stark angreift, Silber jedoch kaum ätzt. Hierbei wird durch die im Flankenbereich zu dünn oder porös ausgebildete Silberschicht in diesem Bereich die Aluminiumschicht weggeätzt. In den dicht mit Silber geschützten ersten und zweiten Bereichen gelangt die Ätzlösung nicht an die Aluminiumschicht, sodaß diese dort weitgehend unversehrt bleibt.

Abschließend werden (in Schritt i) die Basiskontakte 10 mittels eines Lasers durch das darunterliegende Oxid 49 getrieben, um die Basisbereiche der Solarzelle durch lokale Kontakte 57 elektrisch zu kontaktieren. Dieser Prozeß ist als LFC-Verfahren (Laser Fired Contacts, siehe DE 100 46 170 A1) bekannt. Zuletzt folgt noch ein Tempern für 1 bis 3 Minuten bei etwa 330°C.

Mit Bezug auf Fig. 3 wird eine weitere Ausführungsform einer erfindungsgemäßen Solarzelle erläutert.

Wie oben beschrieben wird eine Solarzelle (12) mit einem Halbleitersubstrat (13) vorgeschlagen, dessen elektrische Kontaktierung auf der Halbleitersubstratrückseite (14) erfolgt. Die Halbleitersubstratrückseite weist lokal n-dotierte Bereiche (15) auf, welche durch feine Bohrungen (16) mit der Halbleitersubstratvorderseite (17) verbunden sind. Die Halbleitersubstratvorderseite sowie die feinen Bohrungen sind ebenfalls mit der n-dotierten Schicht versehen. Das Halbleitersubstrat selbst ist p-dotiert.

Die Halbleitersubstratrückseite weist lokal schmale grabenförmige Bereiche (18) auf, welche durch flankenartige Strukturen (19) zu den breiten erhabenen Bereichen (20) der Halbleitersubstratrückseite begrenzt sind.

Die Halbleitersubstratrückseite ist zunächst ganzflächig mit einer Dielektrischen Schicht (21) versehen. Die Dielektrische Schicht ist lokal mit Öffnungen (22) zum n-dotierten Bereich und Öffnungen (23) zum p-dotierten Bereich versehen.

Die Dielektrische Schicht einschließlich der geöffneten Bereiche (22, 23) ist ganzflächig mit einem elektrisch leitfähigen Material (24), vorzugsweise Aluminium beschichtet. Die Beschichtung erfolgt vorzugsweise durch Aufdampfen oder Aufsputtern. Auf diese Schicht ist anschließend eine weitere, elektrisch leitfähige und lötfähige Schicht (25), vorzugsweise Silber oder Kupfer abgeschieden.

Damit die beiden leitfähigen Materialen (24) und (25) die Solarzelle nicht kurzschließen, werden die erhabenen Bereiche (20) der Halbleitersubstratrückseite durch Angriff einer Ätzlösung oder einer Folge von nasschemischen Ätzschritten an den flankenartigen Strukturen (19) getrennt.

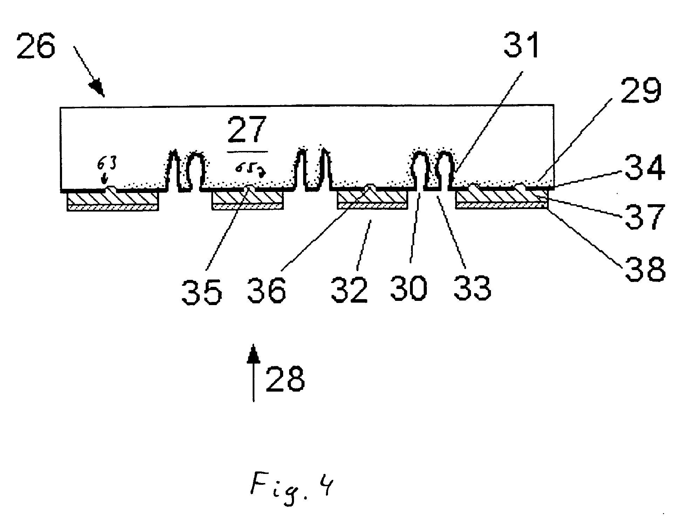

Mit Bezug auf Fig. 4 wird eine weitere Ausführungsform einer erfindungsgemäßen Solarzelle erläutert.

Wie oben beschrieben wird eine Solarzelle (26) mit einem Halbleitersubstrat (27) vorgeschlagen, dessen elektrische Kontaktierung auf der Halbleitersubstratrückseite (28) erfolgt. Die Halbleitersubstratrückseite weist lokal n-dotierte Bereiche (29) auf, das Halbleitersubstrat selbst ist p-dotiert.

Die Halbleitersubstratrückseite weist lokal schmale grabenförmige Bereiche (30) auf, welche durch flankenartige Strukturen (31) zu den breiten erhabenen Bereichen (32) der Halbleitersubstratrückseite begrenzt sind. Jeweils zwei grabenförmige Bereiche (30) liegen dicht nebeneinander und werden durch einen schmalen, erhabenen Bereich (33) voneinander begrenzt.

Die Halbleitersubstratrückseite ist zunächst ganzflächig mit einer Dielektrischen Schicht (34) versehen. Die Dielektrische Schicht ist lokal mit Öffnungen (35) zum n-dotierten Bereich und Öffnungen (36) zum p-dotierten Bereich versehen.

Die dielektrische Schicht einschließlich der geöffneten Bereiche (35, 36) ist zunächst ganzflächig mit einem elektrisch leitfähigen Material (37), vorzugsweise Aluminium beschichtet. Die Beschichtung erfolgt vorzugsweise durch Aufdampfen oder Aufsputtern. Auf diese Schicht ist anschließend eine weitere, elektrisch leitfähige und lötfähige Schicht (38), vorzugsweise Silber oder Kupfer abgeschieden.

Damit die beiden leitfähigen Materialen (37) und (38) die Solarzelle nicht kurzschließen, werden die breiten erhabenen Bereiche (32) der Halbleitersubstratrückseite durch bevorzugten Angriff einer Ätzlösung oder einer Folge von nasschemischen Ätzschritten an den flankenartigen Strukturen (31) und den schmalen, erhabenen Bereich (33) getrennt.

Die in Fig. 4 gezeigte Ausführungsform dient hauptsächlich zur Veranschaulichung der doppelten Gräben (30), die zur besseren elektrischen Trennung zwischen Emitter- und Basiskontakt beitragen. Ein optionaler Emitter an der Substratvorderseite sowie dotierte Verbindungskanäle zwischen rückseitigen und vorderseitigen Emitterbereichen wurden in der Figur aus Übersichtlichkeitsgründen weggelassen.

Alternativ können Ausführungsformen der erfindungsgemäßen Solarzelle wie folgt beschrieben werden Solarzelle aus einem Halbleitersubstrat, vorzugsweise Silizium, dessen elektrische Kontaktierung auf der Halbleitersubstratrückseite erfolgt, dadurch gekennzeichnet, dass die Zellrückseite lokal grabenförmige Bereiche aufweist, welche durch flankenartige Bereiche von den erhabenen Bereichen getrennt sind.

Solarzelle nach einer der vorangehenden Ausführungsformen, dadurch gekennzeichnet, dass entweder die grabenförmige Bereiche der Halbleitersubstratrückseite oder zumindest Teile der erhabenen Bereiche der Halbleitersubstratrückseite durch feine Bohrungen mit der Halbleitersubstratvorderseite verbunden sind.

Solarzelle nach einer der vorangehenden Ausführungsformen, dadurch gekennzeichnet, dass die Zellrückseite zunächst ganzflächig oder nahezu ganzflächig mit einer Schichtfolge aus zumindest zwei elektrisch leitfähigen Materialien beschichtet ist.

Solarzelle nach einer der vorangehenden Ausführungsformen, dadurch gekennzeichnet, dass die zuerst aufgebrachte Schicht aus Aluminium besteht und zumindest eine anschließend aufgebrachte Schicht lötfähig ist.

Solarzelle nach einer der vorangehenden Ausführungsformen, dadurch gekennzeichnet, dass zumindest eine der aufgebrachten Schichten durch Aufdampfen oder Aufsputtern abgeschieden wird.

Solarzelle nach einer der vorangehenden Ausführungsformen, dadurch gekennzeichnet, dass die Trennung der elektrisch leitfähigen Schicht der Zellrückseite in zwei oder mehr Bereiche durch den Angriff einer Ätzlösung oder einer Folge von mehreren naßchemischen Ätzschritten im Bereich der flankenartigen Bereiche erfolgt.

Solarzelle nach einer der vorangehenden Ausführungsformen, dadurch gekennzeichnet, dass jeweils zwei oder mehr grabenförmige Bereiche dicht nebeneinander liegen und durch einen schmalen, erhabenen Bereich voneinander begrenzt werden.

Solarzelle nach einer der vorangehenden Ausführungsformen, dadurch gekennzeichnet, dass die Trennung der elektrisch leitfähigen Schicht der Zellrückseite in zwei oder mehr Bereiche durch den Angriff einer Ätzlösung oder einer Folge von mehreren naßchemischen Ätzschritten im Bereich der flankenartigen Bereiche und des schmalen, erhabenen Bereiches zwischen den dicht nebeneinander liegenden grabenförmigen Bereichen erfolgt. Zusammenfassend kann die Erfindung auch wie folgt beschrieben werden:

Es wird eine Solarzelle (1) mit einem Halbleitersubstrat (2) vorgeschlagen, dessen elektrische Kontaktierung auf der Halbleitersubstratrückseite (3) erfolgt. Die Halbleitersubstratrückseite weist lokal grabenförmige Bereiche (4) auf, welche durch flankenartige Strukturen (5) zur den erhabenen Bereichen (6) der Halbleitersubstratrückseite begrenzt sind.

Die grabenförmigen Bereiche sind durch feine Bohrungen (7) mit der Halbleitersubstratvorderseite (8) verbunden. Die Halbleitersubstratvorderseite sowie die feinen Bohrungen und die grabenförmige Bereiche einschließlich der flankenartigen Strukturen sind mit einer n-dotierten Schicht versehen. Das Halbleitersubstrat selbst ist p-dotiert.

Die Halbleitersubstratrückseite ist zunächst ganzflächig mit einem elektrisch leitfähigen Material (10) beschichtet. Die Beschichtung erfolgt vorzugsweise durch Aufdampfen oder Aufsputtern. Auf diese Schicht ist anschließend eine weitere, elektrisch leitfähige und lötfähige Schicht (11) abgeschieden.

Damit die beiden leitfähige Materialen (10) und (11) die Solarzelle nicht kurzschließen, werden die grabenförmige Bereiche (4) von den erhabenen Bereichen (6) der Halbleitersubstratrückseite durch Angriff einer Ätzlösung oder einer Folge von nasschemischen Ätzschritten an den flankenartigen Strukturen (5) getrennt.

Die erfindungsgemäße Solarzelle und das erfindungsgemäße Herstellungsverfahren wurde mittels der obigen Ausführungsformen lediglich beispielhaft beschrieben. Änderungen und Modifikationen, wie sie ebenfalls im Umfang der beigefügten Patentansprüche liegen, sind dem Fachmann ersichtlich.

Mit der vorgestellten, auch als RISE-EWT-Zelle (Rear Interdigitated Single Evaporation - Emitter Wrap Through) bezeichneten Solarzelle werden unter anderem folgende Vorteile erreicht: Die Zelle ist, unter anderem aufgrund ineinandergreifender Kontaktgitter für Emitter und Basis lediglich auf der Zellrückseite, hocheffizient. Die hochwertigen elektrischen Kontakte werden durch Vakuum-Aufdampfung erzeugt. Es befindet sich ein sammelnder pn-Übergang sowohl an der Vorder- als auch an der Rückseite der Zelle. Die Zelle ist durch eine exzellente Oberflächenpassivierung basierend auf Siliciumnitrid und thermisch gewachsenem Siliciumdioxid geschützt.

Der Herstellungsprozeß zeichnet sich durch Einfachheit und industrielle Umsetzbarkeit aus, da auf Masken- und Lithographieschritte verzichtet wird. Ferner erfolgt die Prozessierung "sanft", d.h. es wird Laserbearbeitung statt mechanischen Bearbeitungsschritten und Vakuumaufdampfung statt Siebdruck für die Kontaktbildung verwendet. Dadurch ist das Verfahren besonders für empfindliche dünne Siliciumwafer geeignet. Das Verfahren hat dadurch ein hohes Kostensenkungspotential.

## Patentansprüche

1. Verfahren zum Herstellen einer Solarzelle (1, 12, 26), aufweisend die folgenden Schritte:
- Bereitstellen eines Halbleitersubstrats (2; 13; 27) mit einer Substratvorderseite (8; 17) und einer Substratrückseite (3; 14; 28);
- Ausbilden eines ersten (4) und eines zweiten Bereichs (6; 20; 32) an der Substratrückseite (3; 14; 28), wobei die Bereiche jeweils im Wesentlichen parallel zu der Substratvorderseite (8;17) sind, und Ausbilden einer geneigten Flanke (5; 19; 31), die den ersten Bereich (4; 18) von dem zweiten Bereich (6; 20; 32) trennt;
- Abscheiden einer Metallschicht (10; 24; 37) zumindest auf Teilbereiche der Substratrückseite (3; 14; 28);
- Abscheiden einer Ätzbarrierenschicht (11; 25; 38) zumindest auf Teilbereiche der ersten Metallschicht (11; 25; 38), wobei die Ätzbarrierenschicht (11; 25; 38) im Wesentlichen resistent gegen eine die Metallschicht ätzende Ätze ist;
- Ätzen der Metallschicht (10; 24; 37) zumindest in Teilbereichen, wobei die Metallschicht (10; 24; 37) an der geneigten Flanke (5; 19; 31) im Wesentlichen entfernt wird.

2. Verfahren nach Anspruch 1, wobei die Ätzbarrierenschicht (11; 25; 38) lötfähig ist.

3. Verfahren nach Anspruch 1 oder 2, wobei die Ätzbarrierenschicht (11; 25; 38) Silber und/oder Kupfer aufweist.

4. Verfahren nach Anspruch 1, 2 oder 3, wobei das Ausbilden der geneigten Flanke (5; 19; 31) derart erfolgt, dass die geneigte Flanke einen Winkel von mindestens 60° zu der Substratvorderseite (8; 17) bildet.

5. Verfahren nach einem der Ansprüche 1 bis 4, wobei das Abscheiden der Ätzbarrierenschicht (11; 25; 38) gerichtet in einer Richtung im Wesentlichen senkrecht zu der Substratvorderseite (8; 17) erfolgt.

6. Verfahren nach einem der Ansprüche 1 bis 5, wobei das Abscheiden der Ätzbarrierenschicht (11; 25; 38) durch Aufdampfen oder durch Aufsputtern erfolgt.

7. Verfahren nach einem der Ansprüche 1 bis 6, wobei das Ausbilden der Flanke (5; 19; 31) mit Hilfe eines Laser erfolgt.

8. Verfahren nach einem der Ansprüche 1 bis 7, wobei das Ausbilden des ersten Bereichs (4) mit Hilfe eines Laser erfolgt.

9. Verfahren nach einem der Ansprüche 1 bis 8, wobei das Ausbilden des ersten Bereichs (4) derart erfolgt, dass der erste Bereich der Substratvorderseite (8; 17) näher ist als der zweite Bereich (6; 20; 32).

10. Verfahren nach einem der Ansprüche 1 bis 9, ferner aufweisend den Schritt des Ausbildens einer dielektrischen Schicht (49; 21; 34) an der Substratrückseite (3; 14; 28) vor dem Ausbilden des ersten und des zweiten Bereichs, wobei beim Ausbilden des ersten Bereichs (4) die dielektrische Schicht (49; 21; 34) im ersten Bereich (4) lokal entfernt wird.

11. Verfahren nach einem der Ansprüche 1 bis 10, ferner aufweisend den Schritt des Ausbildens einer dotierten Emitterschicht (9; 15; 29) sowohl an der Substratvorderseite (8; 17) als auch im ersten Bereich (4) der Substratrückseite (3; 14; 28).

12. Verfahren nach einem der Ansprüche 1 bis 11, ferner aufweisend den Schritt des Ausbildens von emitterdotierten Verbindungskanälen (7; 16), die den ersten Bereich (4) der Substratrückseite (8; 17) mit der Substratvorderseite (3; 14; 28) verbinden.

13. Verfahren nach einem der Ansprüche 1 bis 12, wobei zwischen dem ersten Bereich (4) und dem zweiten Bereich (6; 20; 32) mehrere Flanken (5; 19; 31) ausgebildet werden.

14. Solarzelle (1; 12; 26), aufweisend:
- ein Halbleitersubstrat (2; 13; 27) mit einer Substratvorderseite (8; 17) und einer Substratrückseite (3; 14; 28);
- einen Basisbereich (6; 20; 32) eines ersten Dotierungstyps an der Substratrückseite (3; 14; 28), einen Emitterbereich (4) eines zweiten Dotierungstyps an der Substratrückseite (3; 14; 28) und einen Emitterbereich (9) des zweiten Dotierungstyps an der Substratvorderseite (8), wobei der Basisbereich und der Emitterbereich an der Substratückseite durch einen zu diesen Bereichen geneigt angeordneten Flankenbereich (5; 19; 31) getrennt sind;
- einen Basiskontakt (45), der den Basisbereich (6; 20; 32) wenigstens in Teilbereichen elektrisch kontaktiert, und einen Emitterkontakt (43), der den Emitterbereich (4) an der Substratrückseite wenigstens in Teilbereichen elektrisch kontaktiert, wobei der Basiskontakt (45) und der Emitterkontakt (43) jeweils eine das Halbleitersubstrat kontaktierende erste Metallschicht (10) aufweisen, die jeweils im Wesentlichen parallel zu der Substratvorderseite ist, wobei der Flankenbereich (5; 19; 31) keine Metallschicht aufweist, so dass der Emitterkontakt (43) und der Basiskontakt (45) elektrisch getrennt sind, **dadurch gekennzeichnet daß**
der Emitterbereich (4) an der Substratrückseite durch emitterdotierte Verbindungskanäle (7) mit dem Emitterbereich (9) an der Substratvorderseite verbunden ist.

15. Solarzelle nach Anspruch 14, ferner aufweisend eine lötfähige, die erste Metallschicht (10) mindestens teilweise überdeckende zweite Metallschicht (11).

16. Solarzelle nach Anspruch 15, wobei die zweite Metallschicht (11) Silber und/oder Kupfer aufweist.

17. Solarzelle nach einem der Ansprüche 14 bis 16, wobei die erste Metallschicht (10) Aluminium aufweist.

18. Solarzelle nach einem der Ansprüche 14 bis 17, wobei der Flankenbereich (5; 19; 31) einen Winkel von mehr als 60° zur Substratvorderseite bildet.

19. Solarzelle nach einem der Ansprüche 14 bis 18, wobei der Emitterbereich (4) der Substratrückseite näher zu der Substratvorderseite (8) ist als der Basisbereich (6).

20. Solarzelle nach einem der Ansprüche 14 bis 19, ferner aufweisend eine dielektrische Schicht (49; 21; 34) zwischen dem Basisbereich (6) und dem Basiskontakt (45), wobei der Basiskontakt den Basisbereich durch Öffnungen (57) in der dielektrischen Schicht hindurch lokal kontaktiert.

21. Solarzelle nach einem der Ansprüche 14 bis 20, wobei der Basisbereich (59; 63) von dem Emitterbereich (61; 65) der Substratrückseite durch mindestens einen Graben (18; 30) getrennt ist, der Flankenbereiche (19; 31) aufweist.

## Claims

1. Method for the production of a solar cell (1, 12, 26) comprising the following steps:
- provision of a semiconductor substrate (2; 13; 27) with a substrate front side (8; 17) and a substrate rear side (3; 14; 28),
- formation of a first (4) and a second region (6; 20; 32) on the substrate rear side (3; 14; 28), wherein the regions are each substantially parallel to the substrate front side (8; 17) and formation of an inclined flank (5; 19; 31) separating the first region (4; 18) from the second region (6; 20; 32),
- deposition of a metal layer (10; 24; 37) at least on partial regions of the substrate rear side (3; 14; 28),
- deposition of an etching barrier layer (11; 25; 38) at least on partial regions of the first metal layer (11; 25; 38), wherein the etching barrier layer (11; 25; 38) is substantially resistant to an etching solution etching the metal layer;
- etching of the metal layer (10; 24; 37) at least in partial regions, wherein the metal layer (10; 24; 37) on the inclined flank (5; 19; 31) is substantially removed.

2. Method according to claim 1, wherein the etching barrier layer (11; 25; 38) is solderable.

3. Method according to claim 1 or 2, wherein the etching barrier layer (11; 25; 38) comprises silver and/or copper.

4. Method according to any one of claims 1, 2 or 3, wherein the formation of the inclined flank (5; 19; 31) is performed in such a way that the inclined flank forms an angle of at least 60° to the substrate front side (8; 17).

5. Method according to any one of claims 1 to 4, wherein the deposition of the etching barrier layer (11; 25; 38) is performed directed in a direction substantially perpendicular to the substrate front side (8; 17).

6. Method according to any one of claims 1 to 5, wherein the deposition of the etching barrier layer (11; 25; 38) is performed by vapour deposition or by sputtering.

7. Method according to any one of claims 1 to 6, wherein the formation of the flank (5; 19; 31) is performed with the aid of a laser.

8. Method according to any one of claims 1 to 7, wherein the formation of the first region (4) is performed with the aid of a laser.

9. Method according to any one of claims 1 to 8, wherein the formation of the first region (4) is performed in such a way that the first region is closer to the substrate front side (8; 17) than the second region (6; 20; 32).

10. Method according to any one of claims 1 to 9, further comprising the step of the formation of a dielectric layer (49; 21; 34) on the substrate rear side (3; 14; 28) before the formation of the first and of the second region, wherein, during the formation of the first region (4), the dielectric layer (49; 21; 34) in the first region (4) is locally removed.

11. Method according to any one of claims 1 to 10, further comprising the step of the formation of a doped emitter layer (9; 15; 29) on both the substrate front side (8; 17) and in the first region (4) of the substrate rear side (3; 14; 28).

12. Method according to any one of claims 1 to 11, further comprising the step of the formation of emitter-doped connection ducts (7; 16) connecting the first region (4) of the substrate rear side (8; 17) to the substrate front side (3; 14; 28).

13. Method according to any one of claims 1 to 12, wherein a plurality of flanks (5; 19; 31) is embodied between the first region (4) and the second region (6; 20; 32).

14. Solar cell (1; 12; 26), comprising:
- a semiconductor substrate (2; 13; 27) with a substrate front side (8; 17) and a substrate rear side (3; 14; 28),
- a base region (6; 20; 32) of a first type of dopant on the substrate rear side (3; 14; 28), an emitter region (4) of a second type of dopant on the substrate rear side (3; 14; 28) and an emitter region (9) of the second type of dopant on the substrate front side (8), wherein the base region and the emitter region on the substrate rear side are separated by a flank region (5; 19; 31) arranged inclined toward these regions,
- a base contact (45) electrically contacting the base region (6; 20; 32) at least in partial regions and an emitter contact (43) electrically contacting the emitter region (4) on the substrate rear side at least in partial regions, wherein the base contact (45) and the emitter contact (43) each comprises a first metal layer (10) contacting the semiconductor substrate, which is each substantially parallel to the substrate front side, wherein the flank region (5; 19; 31) does not have a metal layer, so that the emitter contact (43) and the basic contact (45) are electrically separated, **characterised in that**
the emitter region (4) on the substrate rear side is connected by emitter-doped (8; 17) connection channels (7) to the emitter region (9) on the substrate front side.

15. Solar cell according to claim 14, further comprising a solderable second metal layer (11) at least partially covering the first metal layer (10).

16. Solar cell according to claim 15, wherein the second metal layer (11) comprises silver and/or copper.

17. Solar cell according to any one of claims 14 to 16, wherein the first metal layer (10) comprises aluminium.

18. Solar cell according to any one of claims 14 to 17, wherein the flank region (5; 19; 31) forms an angle of more than 60° to the substrate front side,

19. Solar cell according to any one of claims 14 to 18, wherein the emitter region (4) of the substrate rear side is closer to the substrate front side (8) than the base region (6).

20. Solar cell according to any one of claims 14 to 19, further comprising a dielectric layer (49; 21; 34) between the base region (6) and the base contact (45), wherein the base contact contacts the base region locally through openings (57) in the dielectric layer.

21. Solar cell according to any one of claims 14 to 20, wherein the base region (59; 63) is separated from the emitter region (61; 65) of the substrate rear side by at least one trench (18; 30) with flank regions (19; 31).

## Revendications

1. Procédé de fabrication d'une cellule solaire (1, 12, 26), comprenant les étapes suivantes :
- préparation d'un substrat semi-conducteur (2 ; 13 ; 27) avec une face avant de substrat (8 ; 17) et une face arrière de substrat (3 ; 14 ; 28) ;
- réalisation d'une première (4) et d'une seconde zone (6 ; 20 ; 32) sur la face arrière du substrat (3 ; 14 ; 28), les zones étant chacune essentiellement parallèles à la face avant du substrat (8 ; 17), et réalisation d'un flanc incliné (5 ; 19 ; 31), qui sépare la première zone (4 ; 18) de la seconde zone (6 ; 20 ; 32) ;
- déposition d'une couche métallique (10 ; 24 ; 37) au moins sur des zones partielles de la face arrière du substrat (3 ; 14 ; 28) ;
- déposition d'une couche de barrière anti-corrosive (11 ; 25 ; 38) au moins sur des zones partielles de la première couche métallique (11 ; 25 ; 38), la couche de barrière anti-corrosive (11 ; 25 ; 28) étant essentiellement résistante à une corrosion attaquant la couche métallique ;
- attaque de la couche métallique (10 ; 24 ; 37) au moins dans des zones partielles, la couche métallique (10 ; 24 ; 37) étant alors essentiellement éliminée sur le flanc incliné (5; 19;31).

2. Procédé suivant la revendication 1, dans lequel la couche de barrière anti-corrosive (11 ; 25 ; 38) est apte au brasage.

3. Procédé suivant l'une des revendications 1 et 2, dans lequel la couche de barrière anti-corrosive (11 ; 25 ; 38) renferme de l'argent et/ou du cuivre.

4. Procédé suivant l'une des revendications 1, 2 ou 3, dans lequel la réalisation du flanc incliné (5 ; 19 ; 31) s'effectue de telle sorte que le flanc incliné forme un angle d'au moins 60° par rapport à la face avant du substrat (8; 17).

5. Procédé suivant l'une des revendications 1 à 4, dans lequel la déposition de la couche de barrière anti-corrosive (11 ; 25 ; 38) s'effectue dans une direction essentiellement perpendiculaire à la face avant du substrat (8 ; 17).

6. Procédé suivant l'une des revendications 1 à 5, dans lequel la déposition de la couche de barrière anti-corrosive (11 ; 25 ; 38) s'effectue par métallisation sous vide ou par pulvérisation cathodique.

7. Procédé suivant l'une des revendications 1 à 6, dans lequel la réalisation des flancs (5 ; 19 ; 31) s'effectue à l'aide d'un laser.

8. Procédé suivant l'une des revendications 1 à 7, dans lequel la réalisation de la première zone (4) s'effectue à l'aide d'un laser.

9. Procédé suivant l'une des revendications 1 à 8, dans lequel la réalisation de la première zone (4) s'effectue de telle sorte que la première zone est plus proche de la face avant du substrat (8 ; 17) que la seconde zone (6 ; 20 ; 32).

10. Procédé suivant l'une des revendications 1 à 9, comprenant en outre l'étape de la réalisation d'une couche diélectrique (49 ; 21 ; 34) sur la face arrière du substrat (3 ; 14 ; 28) avant la réalisation de la première et de la seconde zone, la couche diélectrique (49 ; 21 ; 34) étant éliminée localement dans la première zone (4) lors de la réalisation de cette dernière.

11. Procédé suivant l'une des revendications 1 à 10, comprenant en outre l'étape de la réalisation d'une couche émettrice dopée (9 ; 15 ; 29), aussi bien sur la face avant du substrat (8 ; 17) que dans la première zone (4) de la face arrière du substrat (3 ; 14 ; 28).

12. Procédé suivant l'une des revendications 1 à 11, comprenant en outre l'étape de la réalisation de canaux de jonction (7 ; 16) dopés aux émetteurs, qui relient la première zone (4) de la face arrière du substrat (8, 17) à la face avant du substrat (3 ; 14 ; 28).

13. Procédé suivant l'une des revendications 1 à 12, dans lequel plusieurs flancs (5 ; 19 ; 31) sont réalisés entre la première zone (4) et la seconde zone (6 ; 20 ; 32).

14. Cellule solaire (1 ; 12 ; 26), comportant :
- un substrat semi-conducteur (2 ; 13 ; 27) avec une face avant de substrat (8 ; 17) et une face arrière de substrat (3 ; 14 ; 28) ;
- une zone de base (6 ; 20 ; 32) d'un premier type de dopage sur la face arrière du substrat (3 ; 14 ; 28), une zone émettrice (4) d'un second type de dopage sur la face arrière du substrat (3 ; 14 ; 28) et une zone émettrice (9) du second type de dopage sur la face avant du substrat (8), la zone de base et la zone émettrice sur la face arrière du substrat étant séparées par une zone de flancs (5 ; 19 ; 31) inclinée par rapport à ces zones ;
- un contact de base (45), qui est au contact électrique de la zone de base (6 ; 20 ; 32) au moins dans des zones partielles, et un contact émetteur (43), qui est au contact électrique de la zone émettrice (4) sur la face arrière du substrat au moins dans des zones partielles, le contact de base (45) et le contact émetteur (43) présentant chacun une première couche métallique (10) au contact du substrat semi-conducteur, laquelle couche est essentiellement parallèle à la face avant du substrat, la zone de flancs (5 ; 19 ; 31) ne présentant aucune couche métallique, de sorte que le contact émetteur (43) et le contact de base (45) sont séparés électriquement, **caractérisée en ce que** la zone émettrice (4) sur la face arrière du substrat est reliée par des canaux de jonction (7) dopés aux émetteurs à la zone émettrice (9) sur la face avant du substrat.

15. Cellule solaire suivant la revendication 14, comportant en outre une seconde couche métallique (11) apte au brasage, qui recouvre au moins en partie la première couche métallique (10).

16. Cellule solaire suivant la revendication 15, dans laquelle la seconde couche métallique (11) renferme de l'argent et/ou du cuivre.

17. Cellule solaire suivant l'une des revendications 14 à 16, dans laquelle la première couche métallique (10) renferme de l'aluminium.

18. Cellule solaire suivant l'une des revendications 14 à 17, dans laquelle la zone de flancs (5 ; 19 ; 31) forme un angle de plus de 60° par rapport à la face avant du substrat.

19. Cellule solaire suivant l'une des revendications 14 à 18, dans laquelle la zone émettrice (4) de la face arrière du substrat est plus proche de la face avant du substrat (8) que la zone de base (6).

20. Cellule solaire suivant l'une des revendications 14 à 19, comportant en outre une couche diélectrique (49 ; 21 ; 34) entre la zone de base (6) et le contact de base (45), le contact de base étant au contact local de la zone de base au travers d'ouvertures (57) dans la couche diélectrique.

21. Cellule solaire suivant l'une des revendications 14 à 20, dans laquelle la zone de base (59 ; 63) est séparée de la zone émettrice (61 ; 65) de la face arrière du substrat par au moins une fosse (18 ; 30), qui présente des zones de flancs (19 ; 31).
